(19) Europäisches Patentamt

European Patent Office

Office européen des brevets

(11) Veröffentlichungsnummer: **0 186 051 B1**

(12) **EUROPÄISCHE PATENTSCHRIFT**

(45) Veröffentlichungstag der Patentschrift: **17.07.91**

(51) Int. Cl.⁵: **G11C 29/00**

(21) Anmeldenummer: **85115798.2**

(22) Anmeldetag: **11.12.85**

(54) **Integrierter Halbleiterspeicher.**

(30) Priorität: **28.12.84 DE 3447761**

(43) Veröffentlichungstag der Anmeldung:
**02.07.86 Patentblatt 86/27**

(45) Bekanntmachung des Hinweises auf die
Patenterteilung:
**17.07.91 Patentblatt 91/29**

(84) Benannte Vertragsstaaten:
**AT DE FR GB IT NL**

(56) Entgegenhaltungen:
**EP-A- 0 055 129**
**EP-A- 0 186 040**
**EP-A- 0 214 508**

**PATENT ABSTRACTS OF JAPAN, Band 6, Nr.**
**62 (P-111)[940], 21. April 1982; & JP-A-57 3298**
**(NIPPON DENKI K.K.) 08-01-1982**

**PATENT ABSTRACTS OF JAPAN, Band 6, Nr.**
**34 (P-104)[912], 2. März 1982; & JP-A-56 153**
**596 (NIPPON DENKI K.K.) 27-11-1981**

**ELEKTRONIK, Nr. 15, 30. Juli 1982, Seiten**
**27-30, München, DE; P. MATTOS et al.:**
**""Nibble-mode" beschleunigt Speicherzug-**
**riff"**

(73) Patentinhaber: **Siemens Aktiengesellschaft**
**Wittelsbacherplatz 2**
**W-8000 München 2(DE)**

(72) Erfinder: **Hoffmann, Kurt, Dr. Prof.**
**Nelkenweg 20**
**W-8028 Taufkirchen(DE)**

## Beschreibung

Die Erfindung betrifft einen integrierten Halbleiterspeicher nach dem Oberbegriff des Patentanspruches 1. Ein solcher ist beispielsweire in EP-A-55129 bischrieben.

Halbleiterspeicher mit Blockunterteilung sind z.B. aus IEEE International Solid-State Circuits Conference 1981, Seiten 84 bis 85 und aus Elektronik, Nr. 15, 30.7.1982, Seiten 27 bis 30 bekannt. Bei diesen gattungsgemäßen Halbleiterspeichern ist es bekannt, einen gesamten Speicherbereich, der dem Anwender gegenüber 1-Bit breite Datenschnittstellen für Datenein- und -ausgabe hat, in n einander gleiche Zellenfelder aufzuteilen. Dazu ist es üblich, jedem Zellenfeld speicherintern eine eigene Datenleitung zuzuordnen, die alle über eine erste Datenweiche mit einem Dateneingangsanschluß verbunden sind. Im Betrieb erfolgt die Auswahl, welche der n Datenleitungen auf den Dateneingangsanschluß durchgeschaltet werden soll, über den bzw. eine entsprechende Anzahl von höchstwertigen Adreßeingang (-eingängen). Analog dazu sind die n Datenleitungen mit einem Datenausgangsanschluß über eine zweite Datenweiche verbunden.

Der Wert von n ist geradzahlig. Er ist weiterhin gleich der Anzahl der gewünschten Zellenfelder und hängt davon ab, ob an Adreßeingängen, über die der Halbleiterspeicher ja bekanntlich adressiert wird, einfache Adreßsignale, d.h. nur sogenannte X-Adressen bzw. Y-Adressen angelegt werden, oder aber solche Adreßsignale, die innerhalb einer Taktperiode des Halbleiterspeichers nacheinander sowohl eine X-Adresse als auch eine Y-Adresse enthalten (Adreßmultiplexing). In diesem Fall kann n nur eine durch 4 teilbare Zahl sein

Des weiteren sind auch Halbleiterspeicher bekannt, die mehr als 1-Bit breite Datenschnittstellen für Datenein- und -ausgabe haben. Typische Organisationsformen dazu sind Datenschnittstellen in einer Breite von m = 4, 8 und 9 Bit. Solcher Art gestaltete Halbleiterspeicher enthalten aufgrund der fortschreitenden Integrationsmöglichkeiten immer mehr Speicherzellen. Die Zunahme an Speicherzellen je Halbleiterspeicher bedingt jedoch sowohl bei dessen Hersteller als auch beim Kunden, der ja in aller Regel eine sogenannte "incoming inspection" durchführt, einen erhöhten zeitlichen, personellen und finanziellen Aufwand zur Prüfung (Testen) von Halbleiterspeichern. Aufgrund der speziellen, notwendigen Ausgestaltung von Prüfmustern für das Testen steigt die zum Testen notwendige Zeit sogar exponentiell mit der Zunahme an Speicherzellen an. Aus diesem Grunde ist es wünschenswert, die Prüfzeit deutlich verkürzen zu können, ohne die verwendeten Prüfmuster in ihrer Effizienz beschneiden zu müssen. Frühere Versuche mit integrierten Schaltkreisen, bei denen mehrere Halbleiterchips bzw. -bausteine parallel von einem Prüfautomaten getestet wurden, ergaben zwar eine hervorragende Prüfzeitverkürzung, der notwendige mechanische Aufwand dazu (Prüfspitzen auf Scheibenebene, Meßfassungen mit Kabeln, auf Bausteinebene) war jedoch sehr groß. Außerdem mußten vorhandene Prüfprogramme auf komplizierte Art und Weise angepaßt werden.

Aufgabe der vorliegenden Erfindung ist es deshalb, einen integrierten Halbleiterspeicher zu schaffen, der es ermöglicht, die Prüfzeit ohne Verlust an Effizienz der eingesetzten Prüfmuster deutlich zu verkürzen.

Diese Aufgabe wird erfindungsgemäß gelöst durch die kennzeichnenden Merkmale des Patentanspruches 1. Grundgedanke der Erfindung ist dabei, einen Halbleiterspeicher so auszugestalten, daß er zwar einerseits wie üblich (Normalfall) betrieben werden kann, es jedoch andererseits (Testfall) möglich ist, Teilbereiche des Halbleiterspeichers speicherintern parallel zu schalten und speicherintern im Testfall erkennen zu können, ob die parallel geschalteten Teilbereiche denselben Dateninhalt haben (Gut-Fall) oder nicht (Fehler-Fall).

Vorteilhafte Weiterbildungen und Ausprägungen der Erfindung sind in Unteransprüchen gekennzeichnet. Die Erfindung ist u.a. anwendbar sowohl auf DRAM's und SRAM's als auch auf EPROM's und EEPROM's.

Im folgenden wird die Erfindung anhand von Figuren näher beschrieben. Es zeigen:

| | |
|---|---|
| Fig. 1 | eine erste Ausführungsform der Erfindung, |
| Fig. 2 | eine weitere Ausgestaltung einer Auswerteschaltung AS, |
| Fig. 3 | eine zweite Ausführungsform der Erfindung, |
| Fig. 4 | eine dritte Ausführungsform der Erfindung, |
| Fig. 5 | die erste Ausführungsform der Erfindung, angewandt auf einen Speicher mit acht Zellenfeldern, |
| Fig. 6 | die erste Ausführungsform der Erfindung, angewandt auf einen Speicher mit Datenschnittstellen in einer Breite von 2 Bit. |

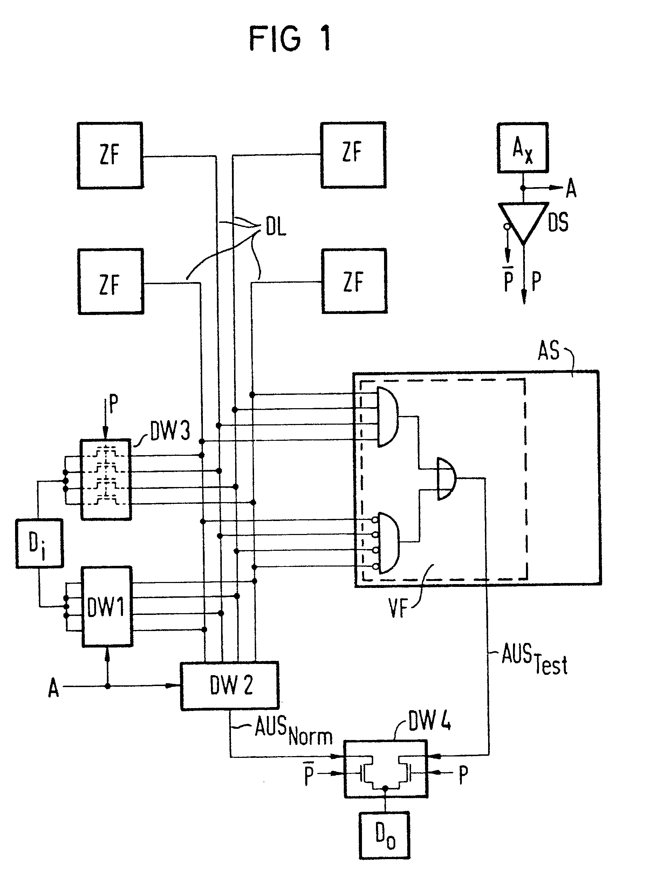

Gemäß Fig. 1 enthält ein erfindungsgemäßer Halbleiterspeicher mit m = 1 Dateneingangsanschluß $D_i$ und m = 1 Datenausgangsanschluß $D_o$ n = 4 einander gleiche Zellenfelder ZF (z. B. bei einem "Megabit"-Speicher: Gesamtanzahl der Speicherzellen: 1024 k . 1 Bit = 1 M . 1 Bit, dies ergibt bei n = 4 vier Zellenfelder ZF à 256 k . 1 Bit). An jedes Zellenfeld ZF ist eine von n Datenleitungen DL angeschlossen. Diese dienen dem Einschreiben von Informationen in die Zellenfelder ZF bzw. zu deren Auslesen. In bekannter Weise sind diese n = 4 Datenleitungen DL über eine erste Datenweiche DW1 mit dem Dateneingangsanschluß $D_i$ verbunden. Zum Einschreiben von Information in den Speicher wird durch Ansteuerung der ersten Datenweiche DW1 mittels einer bestimmten Adresseninformation, nämlich einem Adressierungssignal A, das am höchstwertigen ($A_x$) von vorhandenen Adreßanschlüssen liegt, im Normalbetrieb die am Dateneingangsanschluß $D_i$ anliegende Information auf eine der n = 4 vorhandenen Datenleitungen DL geschaltet, von wo aus sie in das entsprechende Zellenfeld ZF eingeschrieben wird. Entsprechend dazu sind die Datenleitungen DL über eine zweite Datenweiche DW2 mit dem Datenausgangsanschluß $D_o$ verbunden. Diese wird adressierungsmäßig genauso angesteuert wie die erste Datenweiche DW1. Sie schaltet eine der n Datenleitungen DL auf den Datenausgangsanschluß $D_o$. Diese bisher beschriebenen Teile eines erfindungsgemäßen Halbleiterspeichers sind für sich allein bereits bekannt. Sie finden beispielsweise Anwendung in Halbleiterspeichern, die die sogenannten "Nibble-Mode"-Betriebsweise erlauben.

Der erfindungsgemäße Halbleiterspeicher enthält nun in vorteilhafter Art und Weise, parallel zur ersten Datenweiche DW1 eine dritte Datenweiche DW3, mittels derer im Testbetrieb am Dateneingangsanschluß $D_i$ anliegende Informationen gleichzeitig auf alle n = 4 Datenleitungen DL übergeben werden. Die dritte Datenweiche DW3 kann beispielsweise n = 4 parallel geschaltete Transistoren enthalten, deren eine Seite ihrer Durchlaßstrecken gemeinsam an den Dateneingangsanschluß $D_i$ angeschlossen sind und deren andere Seiten an je eine Datenleitung DL angeschlossen sind. Gatemäßig angesteuert werden die Transistoren der dritten Datenweiche DW3 durch ein Steuersignal P, dessen Erzeugung später beschrieben wird Schreibt man über diese dritte Datenweiche DW3 Informationen in die Zellenfelder ZF, so enthalten diese Zellenfelder ZF untereinander dieselben Informationen

Betrachtet man nun im Testbetrieb jedes der Zellenfelder ZF als einen eigenen Speicher (Prüfling), so kann man die (Test-)Informationen, die adressierungsmäßig auf ein Zellenfeld ZF abgestimmt sein müssen, gleichzeitig parallel in alle Zellenfelder ZF einschreiben.

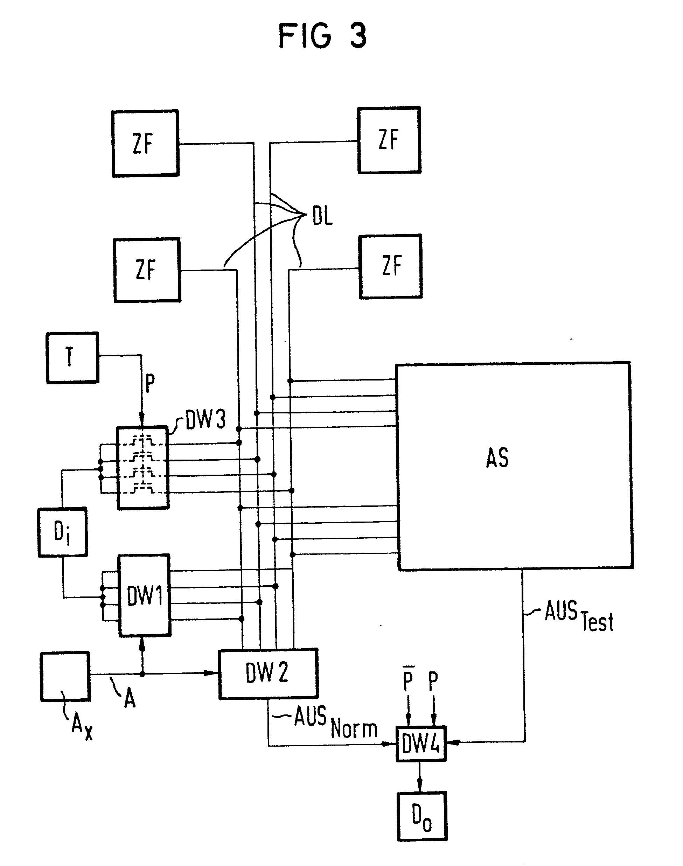

Das Steuersignal P, das die dritte Datenweiche DW3 aktiviert, kann auf verschiedene Arten gewonnen werden. In einer Ausführungsform gemäß Fig 3 wird im Testfall an einen weiteren Anschluß T ein Testsignal in Form eines konstanten Potentiales (z.B. log. '1') angelegt. Im Normalbetrieb wird entweder ein konstantes Potential z.B. mit dem Wert '0' angelegt oder aber der Anschluß T bleibt unbeschaltet. Das so erzeugte Steuersignal P, das direkt am Anschluß T abgegriffen werden kann, steuert dann u.a. die Gates der dritten Datenweiche DW3 an, so daß deren Transistoren durchschalten. Diese Lösung hat einerseits den Vorteil, einen Potentialwert wählen zu können, der sonst auch zur Ansteuerung des Halbleiterspeichers verwendet wird (z.B. "TTL-Pegel"). Andererseits wird aber für den Anschluß T ein zusätzlicher Anschluß benötigt, der unter Umständen aufgrund von Gehäuseabmessungen des Halbleiterspeichers nicht verfügbar ist.

In einer anderen Ausführungsform, dargestellt in Fig. 1, wird ein Anschluß mitbenutzt, der ansonsten für den Normalbetrieb benützt wird. Als geeignetster Anschluß bietet sich ein Anschluß an, der der Ansteuerung des Halbleiterspeichers mit Adreßinformationen dient, insbesondere der für die höchstwertige X- bzw. Y- bzw. X/Y-Information (beim heute üblichen Adreßmultiplexverfahren). Im Normalbetrieb wird an einen solchen Anschluß bei heute üblichen Halbleiterspeichern beispielsweise ein (höchstwertiges) Adreßsignal A mit einem '0'-Pegel von 0 Volt und einem '1'-Pegel von 5 Volt angelegt. Bei der Ausführungsform des erfindungsgemäßen Halbleiterspeichers nach Fig. 1 wird dieser Anschluß allgemein mit $A_x$ bezeichnet. An diesem liegt im Normalfall die höchstwertige X/Y-Adreßinformation. Für den Testbetrieb wird ein Potential angelegt, das z.B. deutlich über dem '1'-Pegel des üblichen, am Adressanschluß $A_x$ anliegenden Adreßsignales A liegt, beispielsweise 10 V. Eine nachgeschaltete Diskriminatorschaltung DS erkennt dieses angelegte Potential und erzeugt das halbleiterspeicherinterne Steuersignal P. Diskriminatorschaltungen DS sind als solche an sich bekannt, beispielsweise in Form von Schwellwertschaltern. Bekannte Schwellwertschalter sind z.B. der DE-OS 30 30 852 und der DE-0S 33 18 564 entnehmbar. Es sind jedoch auch andere Ausgestaltungen nach dem Stande der Technik denkbar.

Des weiteren enthält ein erfindungsgemäßer Halbleiterspeicher noch m einander gleiche Auswerteschaltungen AS (m = Breite der Datenschnittstellen für Datenein- und -ausgabe).

Aufgabe jeder dieser Auswerteschaltungen AS ist es, beim Auslesen aus dem Halbleiterspeicher die auf den der jeweiligen Auswerteschaltung AS zugeordneten n Datenleitungen DL anliegende Informationen zu Übernehmen und sie in dem Falle, wo alle diese Informationen untereinander gleich sind (was aufgrund von zuvor stattgefundenem parallelem Abspeichern in die Zellenfelder ZF ja dem "Gut-Fall" entspricht), an einem Ausgang $AUS_{Test}$ ein Signal zu erzeugen, das einen ersten logischen Pegel hat, und dieses an den Datenausgangsanschluß $D_o$ weiterzuleiten, und in dem Falle, in dem diese Daten einander nicht gleich sind (Fehlerfall), an ihrem Ausgang $AUS_{Test}$ ein Fehlersignal mit einem zweiten logischen Pegel zu erzeugen, der komplementär zum ersten logischen Pegel ist, und dieses an den Datenausgangsanschluß $D_o$ weiterzuleiten, sodaß es z.B. ein an den Datenausgangsanschluß $D_o$ angeschlossener Prüfautomat als aktiviertes Fehlersignal erkennen kann. Aufgrund der verwendeten binären Logik besitzt dieses aktivierte Fehlersignal im Fehlerfall z.B. den Wert log. '0' (eine umgekehrte Definition ist selbstverständlich denkbar).

Ein Prüfautomat braucht dann im Testfall nur noch zu erkennen, welcher der beiden logischen Pegel am Datenausgangsanschluß $D_o$ anliegt, um auf "Fehler" oder "gut" entscheiden zu können. Hervorzuheben ist, daß das am Ausgang $AUS_{Test}$ der Auswerteschaltung AS (und damit das am Datenausgangsanschluß $D_o$) anliegende Signal nicht eine aus dem Halbleiterspeicher ausgelesene Speicherinformation darstellt, sondern das Ergebnis einer in der Auswerte-Schaltung AS bereits durchgeführten Prüfung.

Für übliche Serienprüfungen beim Hersteller (auf Scheibenebene, mit und ohne redundante Speicherzellen, auf Bausteinebene) sowie für incoming inspection beim Kunden ist diese Art zu testen völlig ausreichend; Prüfen zu Analysezwecken oder ähnliches ist wegen der bei Parallelprüfung innerhalb eines Halbleiterspeichers anfallenden Adressierungsungenauigkeit (welches Zellenfeld ZF ist defekt ?) nicht möglich.

Des weiteren ist es nicht notwendig, folgenden Fehlerfall erkennen zu müssen: alle zu einem bestimmten Zeitpunkt in den parallel geschalteten Zellenfeldern ZF adressierte Speicherzellen sind defekt, d. h. sie enthalten eine falsche Information. Dieser Fehlerfall wird von der Auswerteschaltung AS nicht erkannt. Dies ist jedoch auch nicht notwendig. In einem solchen Falle ist nämlich, wie dem Fachmann durchaus bekannt, der Halbleiterspeicher an einer Vielzahl von Speicherzellen defekt, wobei es dann auch einige Speicherzellen eines Zellenfeldes ZF gibt, die im Testbetrieb mit guten Speicherzellen anderer Zellenfelder ZF parallel geschaltet werden. Dann wird der fehlerhafte Halbleiterspeicher wieder als solcher erkannt.

Dies ist für einfache "Go-/No Go-"Prüfungen völlig ausreichend. Der Vorteil, komplexe, bei herkömmlichen Prüfungen zeitintensive Prüfmuster bei deutlich verkürzter Prüfzeit einsetzen zu können, überwiegt den gezeigten Nachteil bei weitem.

Eine mögliche, vorteilhafte Ausgestaltung der Auswahlschaltung AS ist in Fig. 1 enthalten. Sie wird nachfolgend erläutert.

Die Auswerteschaltung AS enthält eine bekannte Valenzfunktion VF mit einem UND-Gatter, einem als NOR-Funktion geschalteten weiteren UND-Gatter und einem ODER-Gatter. Das Ausgangssignal $AUS_{Test}$ zeigt den Fehlerfall durch den Pegel "log. '1'" an.

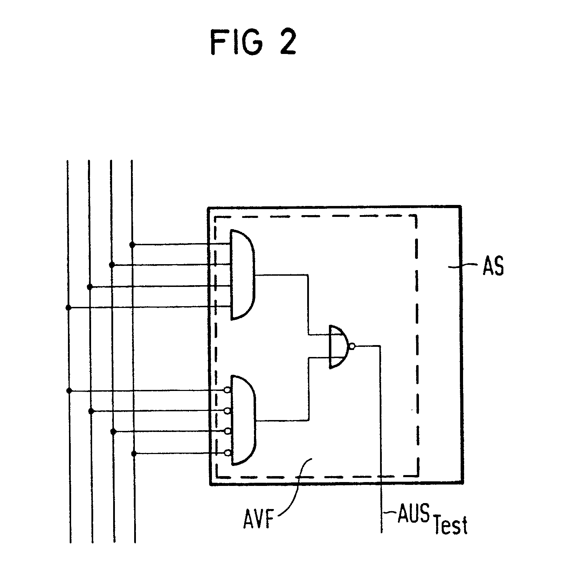

Eine weitere, mögliche Auswerteschaltung AS zeigt Fig. 2. Es ist eine bekannte Antivalenzfunktion AVF dargestellt mit einem UND-Gatter, einem als NOR-Funktion geschalteten weiteren UND-Gatter und einem NOR-Gatter. Das Ausgangssignal $AUS_{Test}$ zeigt den Fehlerfall durch den Pegel "log. '0'" an.

Die Ausführungsform der Erfindung nach Fig. 1 weist auf vorteilhafte Weise noch je Bit der Breite m der Datenschnittstellen eine vierte Datenweiche DW4 auf, die dazu dient, auf den Datenausgangsanschluß $D_o$ im Normalbetrieb die aus der jeweiligen zweiten Datenweiche DW2 austretenden Informationen $AUS_{Norm}$ auf den jeweiligen Datenausgangsanschluß $D_o$ zu schalten und im Testbetrieb statt dessen den Ausgang $AUS_{Test}$ der jeweiligen Auswerteschaltung AS mit dem entsprechenden DO-Anschluß $D_o$ zu verbinden. Diesem Zwecke dienen je vierter Datenweiche DW4 zwei Transistoren. Deren Drain-Anschlüsse sind gemeinsam mit dem zugehörigen Datenausgangsanschluß $D_o$ verbunden. Der Sourceanschluß des einen Transistors ist mit dem Ausgang der zweiten Datenweiche DW2 verbunden, während der Source anschluß des anderen Transistors mit dem Ausgang der Auswerteschaltung AS verbunden ist. Der eine Transistor wird gatemäßig von einem zum Steuersignal P komplementären Signal P angesteuert; der andere vom Steuersignal P. Damit ist es möglich, wahlweise den Ausgang der zweiten Datenweiche DW2 oder den der Auswerteschaltung AS auf den Datenausgangsanschluß $D_o$ zu schalten.

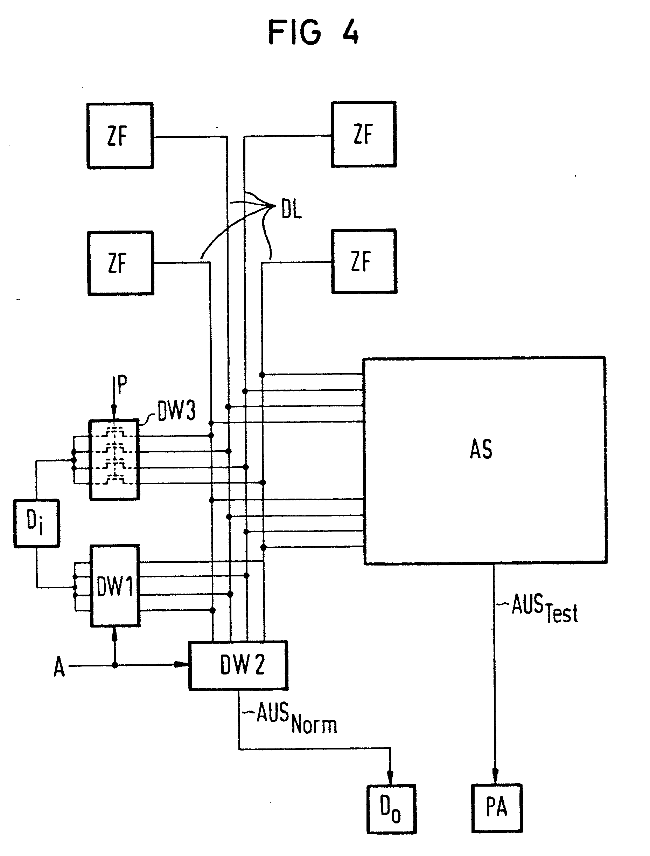

Es ist jedoch in einer anderen Ausführungsform durchaus auch möglich, den Ausgang jeder der zweiten Datenweichen DW2 direkt auf den zugehörigen Datenausgangsanschluß $D_o$ zu schalten und den Ausgang jeder Auswerteschaltung AS, ebenfalls direkt, separat auf einen eigenen Anschluß PA im Sinne eines Prüfanschlusses zu legen. Diese Ausführungsform ist in Fig. 4 gezeigt.

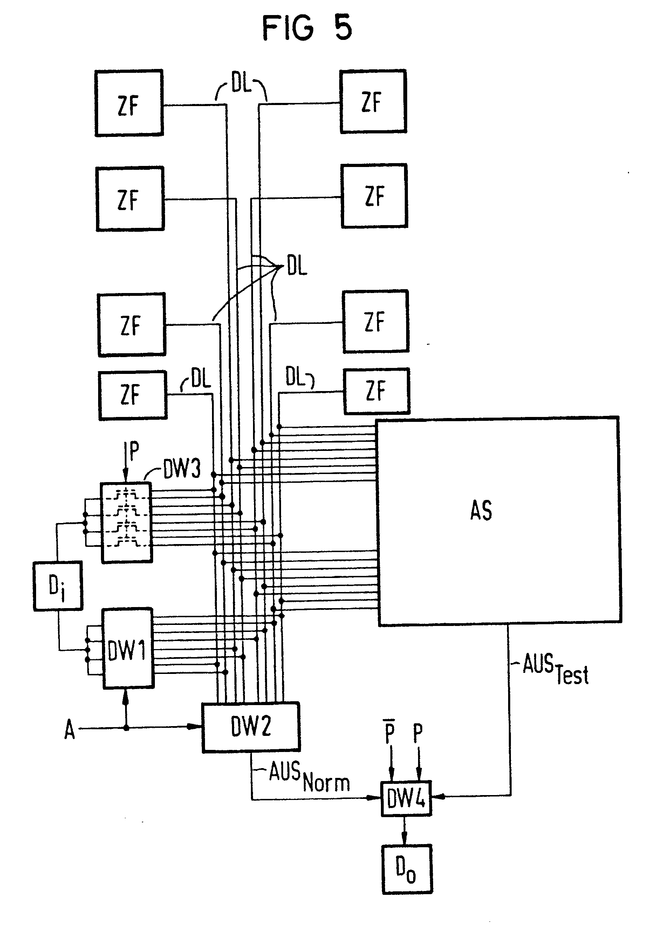

Fig. 5 zeigt eine Ausführungsform eines erfindungsgemäßen Halbleiterspeichers, bei dem anstelle von n = 4 Zellenfelder ZF n = 8 Zellenfelder ZF verwendet werden. Die Funktion des Halbleiterspeichers ist dieselbe wie für Fig. 1 beschrieben. Es tritt jedoch im Testbetrieb eine noch stärkere Reduzierung der Testzeit ein.

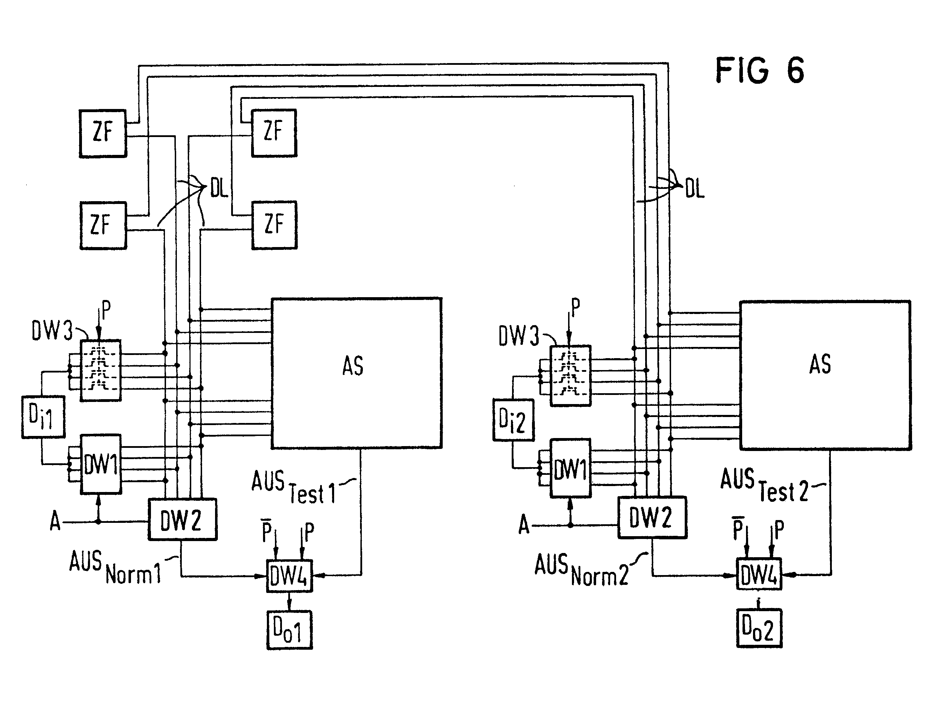

Fig. 6 zeigt eine Ausführungsform eines erfindungsgemäßen Halbleiterspeichers, bei dem wiederum n = 4 Zellenfelder ZF verwendet sind, der jedoch eine Breite von m = 2 Bit bei den Datenschnittstellen besitzt. Die Funktion ist dieselbe, wie in Fig. 1 beschrieben. Es ist lediglich klarzustellen, daß jeweils beide dargestellte erste Datenweichen DW1, zweite Datenweichen DW2, dritte Datenweichen DW3 und vierte Datenweichen DW4, die Zellenfelder ZF sowie die beiden Auswerteschaltungen AS jeweils zueinander parallel und unabhängig voneinander arbeiten. Zur Verdeutlichung der Tatsache, daß die Datenschnittstellen der m = 2 Bits voneinander unabhängige Informationen führen, wurden an Stelle der Bezeichnungen $D_i$, $D_o$, $AUS_{Test1}$, $AUS_{Norm}$, die Bezeichnungen $D_{i1}$, $D_{o1}$, $D_{i2}$, $D_{o2}$, $AUS_{Test1}$, $AUS_{Test2}$, $AUS_{Norm1}$ und $AUS_{Norm2}$ gewählt.

Weitere, verschiedene Ausgestaltungen der vorliegenden Erfindung sind möglich, insbesondere auch bei der Ausgestaltung der Auswerteschaltung AS. Sie liegen jedoch allesamt im Bereiche dieser Erfindung, denn es stellt für den Durchschnittsfachmann kein Problem dar, die aufgezeigten Logikschaltungen abzuändern, ohne dabei die der Erfindung zugrundeliegende Aufgabenstellung oder den Grundgedanken der Erfindung zu verlassen.

## Patentansprüche

1. Integrierter Halbleiterspeicher mit n einander gleichen Speicherzellenfeldern (ZF), mit n . m Datenleitungen (DL) zum Einschreiben und Auslesen von Speicherdaten in die bzw. aus den Speicherzellenfeldern (ZF), mit m ersten Datenweichen (DW1), von denen jede beim Einschreiben an einem ihr zugeordneten Dateneingangsanschluß ($D_i$) anliegende, in den Halbleiterspeicher einzuschreibende Speicherdaten in Abhängigkeit von Adressierungsdaten an jeweils eine der n ihr zugehörigen Datenleitungen (DL) anlegt, mit m zweiten Datenweichen (DW2), von denen jede beim Auslesen von Speicherdaten, die auf jeweils n Datenleitungen (DL) anliegen, in Abhängigkeit von Adressierungsdaten eine der n Datenleitungen (DL) auswählt und über einen Ausgang an einen zugehörigen Datenausgangsanschluß ($D_o$) anlegt, wobei
an jeweils n der n . m Datenleitungen (DL), parallel zu der jeweiligen zweiten Datenweiche (DW2) eine Auswerteschaltung (AS) angeschlossen ist, die als Ausgangssignal ($AUS_{Test}$) ein Signal mit einem ersten logischen Pegel abgibt in dem Falle, in dem alle n an die Auswerteschaltung (AS) angeschlossenen Datenleitungen (DL) untereinander gleiche Speicherdaten enthalten (Gut-Fall), daß die Auswerteschaltung (AS) als Ausgangssignal ($AUS_{Test}$) ein Signal mit einem zweiten logischen Pegel abgibt in dem Falle, in dem die an die Auswerteschaltung (AS) angeschlossenen n Datenleitungen (DL) unterschiedliche Speicherdaten enthalten (Fehlerfall), **dadurch gekennzeichnet,** daß das Ausgangssignal ($AUS_{Test}$) der Auswerteschaltung (AS) an den den n Datenleitungen (DL) zugehörigen Datenausgangsanschluß ($D_o$) angeschlossen ist, daß zwischen jedem der m Dateneingangsanschlüsse ($D_i$) und den zugehörigen n von n . m Datenleitungen (DL), parallel zur jeweiligen ersten Datenweiche (DW1), eine dritte Datenweiche (DW3) geschaltet ist, die in Abhängigkeit von einem Steuersignal (P) die in den Halbleiterspeicher einzuschreibenden Speicherdaten parallel an alle n Datenleitungen (DL) übergibt, daß jedem der m Datenausgangsanschlüsse ($D_o$) eine vierte Datenweiche (DW4) vorgeschaltet ist, die in Abhängigkeit vom Steuersignal (P) und einem zu diesem komplementären Signal ($\overline{P}$) entweder das von der zweiten Datenweiche (DW2) ausgewählte Speicherdatum ($AUS_{Norm}$) oder das von der Auswerteschaltung (AS) erzeugte Ausgangssignal ($AUS_{Test}$) an den Datenausgangsanschluß ($D_o$) durchschaltet, und daß für das Steuersignal (P) ein weiterer Anschluß ($A_x$; T) vorgesehen ist.

2. Integrierter Halbleiterspeicher nach Anspruch 1,
**dadurch gekennzeichnet,** daß jede Auswerteschaltung (AS) eine Valenzfunktion (VF) enthält, deren Eingänge die an die Auswerteschaltung (AS) angeschlossenen n Datenleitungen (DL) bilden, und deren Ausgang das Ausgangssignal ($AUS_{Test}$) der Auswerteschaltung (AS) bildet.

3. Integrierter Halbleiterspeicher nach Anspruch 1,
**dadurch gekennzeichnet,** daß jede Auswerteschaltung (AS) eine Antivalenzfunktion (AVF) enthält, deren Eingänge die an die Auswerteschaltung (AS) angeschlossenen n Datenleitungen (DL) bilden, und deren Ausgang das Ausgangssignal ($AUS_{Test}$) der Auswerteschaltung (AS) bildet.

4. Integrierter Halbleiterspeicher nach einem der vorhergehenden Ansprüche,
**dadurch gekennzeichnet,** daß jede der dritten Datenweichen (DW3) n Transistoren enthält, die mit ihrer Durchlaßstrecke einerseits alle an den zugehörigen Dateneingangsanschluß ($D_i$) und andererseits an je eine der n zu dem jeweiligen Dateneingangsanschluß ($D_i$) gehörigen Datenleitung (DL) angeschlossen sind, und daß deren Gates parallel an das Steuersignal (P) angeschlossen sind.

5. Integrierter Halbleiterspeicher nach einem der vorhergehenden Ansprüche, **dadurch gekennzeichnet,** daß jede der m vierten Datenweichen (DW4) zwei Transistoren enthält, daß die Drainanschlüsse der beiden Transistoren zusammengeschaltet sind und mit dem der jeweiligen vierten Datenweiche (DW4) zugehörigen Datenausgangsanschluß (D$_o$) verbunden sind, daß bei jeder der vierten Datenweichen (DW4) der eine Transistor mit seinem Sourceanschluß mit dem Ausgang der zugehörigen zweiten Datenweiche (DW2) verbunden ist, daß bei jeder der vierten Datenweichen (DW4) der andere Transistor mit seinem Sourceanschluß mit dem Ausgang der zugehörigen Auswerteschaltung (AS) verbunden ist, daß das Gate des einen Transistors mit einem zum Steuersignal (P) komplementären Signal ($\overline{P}$) verbunden ist, und daß das Gate des anderen Transistors mit dem Steuersignal (P) verbunden ist.

6. Integrierter Halbleiterspeicher nach einem der vorhergehenden Ansprüche, **dadurch gekennzeichnet,** daß der weitere Anschluß für das Steuersignal (P) ein eigener, sonst unbenutzter Anschluß (T) des Halbleiterspeichers ist.

7. Integrierter Halbleiterspeicher nach einem der vorhergehenden Ansprüche, **dadurch gekennzeichnet,** daß der weitere Anschluß für das Steuersignal (P) ein Anschluß (A$_X$) ist, der auch für sonstige Signale vom Halbleiterspeicher benutzt wird.

8. Integrierter Halbleiterspeicher nach Anspruch 7,
**dadurch gekennzeichnet,** daß der weitere Anschluß (A$_x$) ein Anschluß ist, an den bei einem Normalbetrieb ein Adreßsignal angelegt wird, das das höchstwertige der Adreßsignale ist.

9. Integriertger Halbleiterspeicher nach Anspruch 7 oder 8,
**dadurch gekennzeichnet,** daß zum Umschalten vom Normalbetrieb auf einen Testbetrieb, bei dem die Auswerteschaltungen (As) benützt werden, ein größeres Potential angelegt wird, als das, das dem Anlegen einer log. "1" entspricht.

10. Integrierter Halbleiterspeicher nach Anspruch 9,
**dadurch gekennzeichnet,** daß das Steuersignal (P) mittels einer Diskriminatorschaltung (DS) aktiviert wird, die erkennt, ob das größere Potential anliegt.

11. Integrierter Halbleiterspeicher nach einem der vorhergehenden Ansprüche, **dadurch gekennzeichnet** daß der Ausgang jeder der m zweiten Datenweichen (DW2) direkt auf den jeweils zugehörigen Datenausgangsanschluß

(D$_o$) geführt ist, während der Ausgang jeder der zugehörigen m Auswerteschaltungen (AS) auf einen eigenen, sonst unbenutzten Anschluß (PA) geführt ist.

**Claims**

1. Integrated semiconductor memory having n identical memory cell fields (ZF), having n m data lines (DL) for writing-in and reading-out memory data into and out of the memory cell fields (ZF), having m first data separators (DW1), each of which is connected to one in each case of the n data lines (DL) associated with it, depending on addressing data, when writing in memory data, to be written into the semiconductor memory, present at a data input terminal (D$_i$) assigned to it, having m second data separators (DW2), each of which selects one of the n data lines (DL), depending on addressing data, and is connected via an output to an associated data output terminal (D$_o$) when reading out memory data which are present on in each case n data lines (DL), in which arrangement there is connected to in each case n of the n m data lines (DL), parallel to the respective second data separator (DW2), an evaluation circuit (AS), which emits as output signal (AUS$_{Test}$) a signal with a first logical level in the case where all n data lines (DL) connected to the evaluation circuit (AS) contain identical memory data (O.K. case), and the evaluation circuit (AS) emits as output signal (AUS$_{Test}$) a signal with a second logical level in the case where the n data lines (DL) connected to the evaluation circuit (AS) contain different memory data (fault case), characterised in that the output signal (AUS$_{Test}$) of the evaluation circuit (AS) is connected to the data output terminal (D$_o$) associated with the n data lines (DL), in that there is connected between each of the m data input terminals (D$_i$) and the associated n of n · m data lines (DL), parallel to the respective first data separator (DW1), a third data separator (DW3), which transfers the memory data to be written into the semiconductor memory in parallel to all n data lines (DL) depending on a control signal (P), in that there precedes each of the m data output terminals (D$_o$) a fourth data separator (DW4), which, depending on the control signal (P) and a signal ($\overline{P}$) complementary to the latter, switches through to the data output terminal (D$_o$) either the memory datum (AUS$_{Norm}$) selected by the second data separator (DW2) or the output signal (AUS$_{Test}$) generated by the evaluation circuit (AS), and in that a further connection (A$_x$ ; T) is provided for the control signal (P).

2.  Integrated semiconductor memory according to Claim 1, characterised in that each evaluation circuit (AS) includes a valence function (VF), the inputs of which form the n data lines (DL) connected to the evaluation circuit (AS), and the output of which forms the output signal (AUS$_{Test}$) of the evaluation circuit (AS).

3.  Integrated semiconductor memory according to Claim 1, characterised in that each evaluation circuit (AS) includes an antivalence function (AVF), the inputs of which form the n data lines (DL) connected to the evaluation circuit (AS) and the output of which forms the output signal (AUS$_{Test}$) of the evaluation circuit (AS).

4.  Integrated semiconductor memory according to one of the preceding claims, characterised in that each of the third data separators (DW3) includes n transistors, which on the one hand are all connected with their conducting state region to the associated data input terminal (D$_i$) and on the other hand to one each of the n data lines (DL) associated with the respective data input terminal (D$_i$), and in that their gates are connected in parallel to the control signal (P).

5.  Integrated semiconductor memory according to one of the preceding claims, characterised in that each of the m fourth data separators (DW4) includes two transistors, in that the drain terminals of the two transistors are connected together and are connected to the data output terminal (D$_o$) associated with the respective fourth data separator (DW4), in that at each of the fourth data separators (DW4) the one transistor is connected by its source terminal to the output of the associated second data separator (DW2), in that at each of the fourth data separators (DW4) the other transistor is connected by its source terminal to the output of the associated evaluation circuit (AS), in that the gate of the one transistor is connected to a signal ($\overline{P}$) complementary to the control signal (P), and in that the gate of the other transistor is connected to the control signal (P).

6.  Integrated semiconductor memory according to one of the preceding claims, characterised in that the further terminal for the control signal (P) is a separate, otherwise unused terminal (T) of the semiconductor memory.

7.  Integrated semiconductor memory according to one of the preceding claims, characterised in that the further terminal for the control signal (P) is a terminal (A$_x$) which is also used for other signals from the semiconductor memory.

8.  Integrated semiconductor memory according to Claim 7, characterised in that the further terminal (A$_x$) is a terminal to which an address signal which is the most significant of the address signals is applied during normal operation.

9.  Integrated semiconductor memory according to Claim 7 or 8, characterised in that, for switching from normal operation to test operation, in which the evaluation circuits (AS) are used, a greater potential is applied than that which corresponds to the applying of a logical "1".

10. Integrated semiconductor memory according to Claim 9, characterised in that the control signal (P) is activated by means of a discriminator circuit (DS), which detects whether the greater potential is applied.

11. Integrated semiconductor memory according to one of the preceding claims, characterised in that the output of each of the m second data separators (DW2) is connected directly to the respectively associated data output terminal (D$_o$), while the output of each of the associated m evaluation circuits (AS) is connected to a separate, otherwise unused terminal (PA).

**Revendications**

1.  Mémoire intégrée à semiconducteurs comportant n ensembles identiques (ZF) de cellules de mémoire, n.m lignes de transmission de données (DL) pour l'enregistrement et la lecture de données de mémoire dans et à partir des ensembles (ZF) de cellules de mémoire, m premiers aiguillages de transmission de données (DW1), dont chacun applique lors de l'enregistrement, en fonction de données d'adressage, à respectivement l'une des n lignes de transmission de données (DE) qui leur sont associées, des données de mémoire qui sont appliquées à une borne d'entrée de données (D$_i$) associée aux aiguillages de transmission de données et qui doivent être enregistrées dans la mémoire à semiconducteurs, et comportant m seconds aiguillages de transmission de données (DW2), dont chacun sélectionne l'une des n lignes de transmission de données (DL), lors de la lecture de données de mémoire qui sont appliquées à n lignes respectives de transmission de données (DL), en fonction de données d'adressage, et raccordent cette ligne, par l'intermédiaire d'une sortie, à une borne associée de sortie de données (D₀), et dans laquelle à respectivement n des n.m lignes de transmission de données (DL) est raccordé, parallèlement au second aiguillage respectif de transmission de données (DW2), un circuit d'évaluation (AS) qui délivre comme signal de sortie (AUS$_{Test}$), un signal possédant un premier niveau logique dans le cas où la totalité des n lignes de transmission de données (DL), raccordées au circuit d'évaluation (AS), contient des données de mémoire identiques entre elles (cas bon), que le circuit d'évaluation (AS) délivre, comme signal de sortie (AUS$_{test}$), un signal possédant un second niveau logique dans le cas où les n lignes de transmission de données (DL) raccordées au circuit d'évaluation (ES) contiennent différentes données de mémoire (cas d'erreur), caractérisée par le fait que le signal de sortie (AUS$_{Test}$) du circuit d'évaluation (AS) est appliqué à la borne de sortie de données (D₀) associée aux n lignes de transmission de données (DL), qu'entre chacune des m bornes d'entrée de données (D$_i$) et les n lignes associées faisant partie des n.m lignes de transmission de données (DL) est branché, parallèlement au premier aiguillage respectif de transmission de données (DW1), un troisième aiguillage de transmission de données (DW3), qui retransmet, en fonction d'un signal de commande P, les données de mémoire devant être enregistrées dans la mémoire à semiconducteurs, en parallèle à la totalité des n lignes de transmission de données (DL), qu'en amont de chacune des m bornes de sortie de données (D₀) est raccordé un quatrième aiguillage de transmission de données (DW4), qui, en fonction du signal de commande (P) et d'un signal (P̄) complémentaire du précédent, transmet directement à la borne de sortie de données (D₀) soit la donnée de mémoire (AUS$_{Norm}$) sélectionnée par le second aiguillage de transmission de données (DW2), soit le signal de sortie (AUS$_{Test}$) produit par le circuit d'évaluation (AS), et qu'une autre borne (A$_x$;T) est prévue pour le signal de commande (P).

2. Mémoire intégrée à semiconducteurs suivant la revendication 1, caractérisée par le fait que chaque circuit d'évaluation (AS) comporte une fonction de valence (VF), dont les entrées forment les n lignes de transmission de données (DL) raccordées au circuit d'évaluation (AS), et dont la sortie forme le signal de sortie (AUS$_{Test}$) du circuit d'évaluation (AS).

3. Mémoire intégrée à semiconducteurs suivant la revendication 1, caractérisée par le fait que chaque circuit d'évaluation (AS) comporte une fonction d'antivalence (AVF), dont les entrées forment les n lignes de transmission de données (DL) raccordées au circuit d'évaluation (AS), et dont la sortie forme le signal de sortie (AUS$_{Test}$) du circuit d'évaluation (AS).

4. Mémoire intégrée à semiconducteurs suivant l'une des revendications précédentes, caractérisée par le fait que chacun des troisièmes aiguillages de transmission de données (DW3) comporte n transistors, qui sont tous raccordés, par leur section de conduction, d'une part, à la borne associée d'entrée de données (D$_i$), et, d'autre part, à l'une respective des n lignes de transmission de données (DL) associée à la borne respective d'entrée de données (D$_i$) et que le signal de commande (P) est appliqué en parallèle à leurs grilles.

5. Mémoire intégrée à semiconducteurs suivant l'une des revendications précédentes, caractérisée par le fait que chacun des m quatrièmes aiguillages de transmission de données (DW4) comporte deux transistors, que les bornes de drain des deux transistors sont interconnectées et raccordées à la borne de sortie de données (D₀) associée au quatrième aiguillage respectif de transmission de données (DW4), que, dans chacun des quatrièmes aiguillages de transmission de données (DW4), un transistor est raccordé par sa borne de source à la sortie du second aiguillage associé de transmission de données (DW2), que dans chacun des quatrièmes aiguillages de transmission de données (DW4), l'autre transistor est raccordé par sa borne de source à la sortie du circuit d'évaluation associé (AS), que la grille d'un transistor reçoit un signal (P̄) complémentaire du signal de commande (P), et que la grille de l'autre transistor est raccordée au signal de commande (P).

6. Mémoire intégrée à semiconducteurs suivant l'une des revendications précédentes, caractérisée par le fait que l'autre borne pour le signal de commande (P) est une borne particulière (T), par ailleurs inutilisée, de la mémoire à semiconducteurs.

7. Mémoire intégrée à semiconducteurs suivant l'une des revendications précédentes, caractérisée par le fait que l'autre borne pour le signal de commande (P) est une borne (A$_x$), qui est également utilisée pour d'autres signaux par la mémoire à semiconducteurs.

8. Mémoire intégrée à semiconducteurs selon la revendication 7, caractérisée par le fait que l'autre borne ($A_x$) est une borne, à laquelle, pendant le fonctionnement normal, est appliqué un signal d'adresse, qui est celui des signaux d'adresses, qui possède le poids maximum.

9. Mémoire intégrée à semiconducteurs suivant la revendication 7 ou 8, caractérisée par le fait que pour la commutation du fonctionnement normal à un fonctionnement de test, lors duquel on utilise les circuits d'évaluation (AS), on applique un potentiel supérieur à celui qui correspond à l'application d'un "1" logique.

10. Mémoire intégrée à semiconducteurs suivant la revendication 9, caractérisée par le fait que le signal de commande (P) est activé au moyen d'un circuit discriminateur (DS) qui identifie si le potentiel supérieur est présent.

11. Mémoire intégrée à semiconducteurs suivant l'une des revendications précédentes, caractérisée par le fait que la sortie de chacun des m seconds aiguillages de transmission de données (DW2) est raccordée directement à la borne respectivement associée de sortie de données ($D_o$),tandis que la sortie de chacun des m circuits associés d'évaluation (AS) est raccordée à une borne particulière (PA), par ailleurs non utilisée.

# FIG 1

# FIG 2

# FIG 3

# FIG 4

# FIG 5

FIG 6

EP 0 186 051 B1